# EUROPEAN PATENT SPECIFICATION

(11) **EP 3 111 240 B1**
(45) Date of publication and mention of the grant of the patent: **14.06.2023**
(21) Application number: 15708874.1
(22) Date of filing: 02.03.2015
(51) Int. Cl.: G01R 1/04, G01N 1/42, G01R 31/28, B01L 7/00, G01N 21/01

(54) **SAMPLE HOLDING SYSTEM**
PROBENHALTESYSTEM
SYSTÈME DE SUPPORT D'ÉCHANTILLON

(30) Priority: 28.02.2014 GB 201403519
(43) Date of publication of application: 04.01.2017
(73) Proprietor: Oxford Instruments Nanotechnology Tools Limited, Abingdon, Oxon OX13 5QX (GB)
(72) Inventor: JEDAMZIK, Dieter, Abingdon, Oxon OX13 5QX (GB); SHARP, Peter, Abingdon, Oxon OX13 5QX (GB)
(74) Representative: Gill Jennings & Every LLP
(86) International application number: PCT/GB2015/050596
(87) International publication number: WO 2015/128679

(56) References cited:
- WO-A1-2008/086627
- WO-A1-2011/156443
- WO-A1-2013/011022
- WO-A1-2013/051713
- DE-A1-102011 115 303
- GB-A- 2 320 098
- JP-A- H0 364 040
- JP-A- H0 989 909
- JP-A- H1 164 348
- JP-A- H06 150 863
- JP-A- S61 233 343
- JP-A- 2003 050 191
- JP-A- 2003 149 278
- KR-A- 20090 125 509
- KR-A- 20130 067 122
- KR-A- 20130 142 366
- US-A- 4 745 277
- US-A- 5 422 498
- US-A- 6 032 724
- US-A1- 2009 224 788
- US-A1- 2010 157 552

## Description

### Field of the Invention

The present invention relates to a sample holding system, for example having an operational temperature range which includes cryogenic as well as elevated temperatures (with respect to ambient temperature).

### Background to the Invention

In certain applications it is desirable to be able to perform experiments/measurements upon samples at temperatures within a temperature range which includes cryogenic temperatures as well as elevated temperatures (above ambient), including potentially any or all intermediate temperatures. The samples which may be studied include MEMs devices, semiconductor devices including integrated circuits and gallium arsenide based devices. In some cases these devices may be operational during their analysis.

At present dedicated sample holders are provided for low temperature use (such as cryogenic temperatures below 200K), whereas different sample holders are provided for high temperature use (above room temperature). As it sometimes the case, if it is desired to make measurements upon a specific sample at different temperatures which do not fall into the operational temperature range of a particular type of sample holder then it is necessary to either transfer the sample between sample holders or prepare two similar samples for different respective sample holders having different corresponding operational temperature ranges. This is inefficient and may act as a source of experimental errors. For example the mounting of a sample to a sample holder it time-consuming, not least since it may involve numerous electrical connections to be made. It is desirable to provide a sample holder which is capable of operating at each of cryogenic and elevated temperatures, thereby removing the need to change sample holder or use different samples. This would increase the operational efficiency of the apparatus, reduce potential sources of error and in some cases enable specialised experiments to be performed which at present are not readily achievable.

Examples of sample holders for use at various different temperatures and in different technical fields are disclosed in US-A-6032724, US-A-5422498, JP-AH1164348, JP-A-H0989908, US-A-4745277, WO-A-2011/156443 and JP-AH0364040, none of which are equipped to enable electrical testing of the sample. KR-A-20090125509 and WO-A-2013/051713 disclose sample holders for unspecified ambient temperatures only while WO-A-2008/086627, US-A-2010/157522 and JP-A-H0364040 disclose sample holders for cryogenic temperatures only, each of which is configured to make electrical connections to the sample.

This invention relates to new designs of sample holders for use over a wide range of temperatures from below 1K to at least 380K and in some examples in excess of 500K. A significant technological advantage of the idea is to remove the need to change sample holder in order to achieve sample monitoring throughout these extensive temperature ranges

### Summary of the Invention

A first aspect of the invention is a sample holding system comprising a sample holder, the sample holder comprising:
a substrate in the form of a circuit board;
one or more sample holder connectors for providing electrical connection to the sample holder;
a sample region for receiving a sample; and
circuitry for providing electrical connection between the said sample holder electrical connectors and a part of the sample holder, through the circuit board, and characterised in that the circuit board comprises a high thermal conductivity ceramic substrate having a surface which is coated with a layer of copper having a thickness of at least 127 µm and being arranged to provide conductive circuitry tracks whereby the circuitry (124) is integral to the circuit board, and wherein the thermal conductivity of the ceramic is in excess of 20 W/m·K, preferably >100 W/m·K, at 20°C, such that the sample holder is adapted to operate over an operational temperature range of below 1K to at least 41 0K.

In its simplest form the sample holding system may comprise only a sample holder as described. However, typically the sample holding system also comprises a sample support to which the sample holder is detachably mounted when in use. Typically the sample support is adapted to be mounted to a cooled part of a mechanical refrigerator (also known as a "cryocooler").

An advantageous concept of the invention is the use of the circuitry for providing electrical connection through the circuit board. This may be for the purpose of providing one or each of electrical power or signals. It will be understood that the circuitry is integral to the circuit board, for example being formed from or within the structure of the circuit board materials, either on the surface of the circuit board or internally within it. Such circuitry replaces much of the need for external or peripheral wiring to be applied by a user, particularly in making electrical connections with the sample region. The circuitry may also include a chip carrier for certain samples. The circuitry is preferably arranged to provide electrical connection between the electrical connector and at least the sample region, this including electrical connection to the sample itself if required.

Other components may be provided as part of the sample holder. For example the sample holder may further comprise a heater for heating the sample region. This may be arranged as a resistive thin film directly deposited onto the sample holder by a sputtering or evaporation method followed by a masking and etching technique (classic semiconductor processing) or alternatively by mounting a surface mount resistor acting as a heater attached to a surface of the circuit board. The circuitry may provide the power for any such heater. Independently, the sample holder may further comprise a temperature sensor for monitoring the temperature of the sample when in the sample region. Again, the temperature sensor may be directly manufactured as an integrated sensor by sputtering or evaporation, masking and etching onto the sample holder, or as a discrete surface mount temperature sensor thermally anchored to the copper surface of the sample holder and connected electrically via the circuitry.

Although various geometries of sample holder are contemplated, typically the sample holder is generally planar having first and second opposing faces and wherein the said sample region is arranged on the first face thereof. If present that heater and/or temperature sensor may also be located on the first face. This may be a face which is presented to the user from an access side of the apparatus when in use.

The first face may be an "experimental side" of the sample holder. The second side may be used primarily as a conduit for thermal and/or electrical connection with the sample support. However, the second side may be arranged as a "reverse side" of the sample holder, the reverse side further comprising one or more of, a further sample region, a further heater, or a further temperature sensor. The reverse side may provide a control experiment, an unrelated experiment or an identical second instance of an experiment relating to a sample on the first side.

The sample holder may be provided with a window for the provision of optical transmission measurements of for optical interaction with the sample region. As will be understood this is rather dependent upon the application in question.

For convenience the sample holder is preferably provided as a "puck".

Typically the sample holding system includes a support to which the sample holder is reversibly coupled, when in use. The reversible coupling may be achieved using one or more physical connectors, the sample holding system being arranged to allow a user to couple the sample holder to the sample support from an access side. Thus, the user may attach the sample support to the sample holder from access direction, without the need to either manually or with the aid of tools, manipulate the sample holder or sample support from any other direction of approach.

It is advantageous for the support is formed from a high thermal conductivity material, such as copper, so as to conduct the cooling power of a refrigeration device thereby enabling the sample holder to achieve cryogenic temperatures readily and quickly. Nickel/Gold-plating may be used (on the sample holder and/or sample support) to provide an oxide free corrosion-resistant thermal contact service for this purpose.

Preferably the physical connectors effect a strong thermal coupling between the sample support and the sample holder whilst, more preferably, simultaneously coupling any cooperating electrical connectors mounted to the sample holder and sample support.

The sample holding system preferably further comprises support connectors, which are typically distinct from the physical connectors and are arranged to couple electrically with said sample holder connectors when in use so as to provide the electrical connection from the sample support to the sample holder. Various connector functionalities may be used, although those which provide a user with a reliable and simple coupling are preferred. This sample holder may have a number of electrical DC and/or RF connectors for user measurements and good thermal coupling of the sample holder to a cryogenic cooling apparatus. Thus one or each of the sample holder connectors and sample support connectors are preferably spring loaded probe-pins or push-fit connectors, again allowing ease of detachment and reattachment by a user.

As mentioned the operational temperature range of the sample holder is from below 1K to 380K. In particular this lowest end of the temperature range may be 2K or 2.5K. The upper boundary of the temperature range is preferably increased to at least 410K, preferably 450K and even more preferably in excess of 500K. To achieve an operational temperature range of 380K or higher, the circuit board comprises a high thermal conductivity ceramic substrate having a surface to which is bonded a layer of copper. The copper may be integral with the circuit board. Furthermore it may be provided upon opposed external planar surfaces of the circuit board. Nickel/Gold-plating may also be used as described previously.

Copper clad ceramic circuit boards allow the highest operational temperatures of the sample holder to be significantly in excess of known materials such as "PCB"s or Hydrocarbon copper laminates. The thermal conductivity of the ceramic is preferably in excess of 20 W/m·K, more preferably >100 W/m·K at 20°C. High thermal conductivities promote responsiveness to thermal sinks/inputs and reduce unwanted thermal gradients, particularly across the thickness of the circuit board. The copper layer is also "thick" in comparison with copper on a PCB. This enhances the thermal performance and therefore the or each copper layer has a thickness of at least 127 micrometres. Typically the ceramic is arranged in a generally planar form and said layer of copper is provided upon two opposed planar faces of the circuit board.

A preferred operational temperature range of the sample holder is below 1K to at least 450K, although lower temperatures are feasible, as are temperatures in excess of 450K, particularly with novel material circuit boards. In many cases the sample region is provided with a window for the provision of optical transmission measurements of or optical interaction with the sample region. This invention will also be applied to B field and Temp systems in variable temperature inserts.

Suitable "ceramic" circuit boards, particularly beneficial for operation at elevated temperatures may be obtained from Rogers Corporation (www.curamik.com). The applicant has realised that these copper covered ceramic substrates provide great advantage for use in cryogenic environments (<200K). In practice a typical practical application will be at <5K. The broad temperature range allows for the potential use of the technology in all cryogenic environments including its use in systems which are used with low and high temperature superconducting (LTS & HTS) applications.

This new use of such materials in cryogenic applications meets a clear need in terms of the performance advantage for cryogenic environments.

In essence the ceramic board with the thick OFCu (oxygen free copper) laminates has thermal conductivity properties which vary over the temperature range from below 1K to 500K. At temperatures below 200K the thermal conductivity improves (which is excellent for cooling applications) and above 200K the thermal conductivity deteriorates (which is excellent for applications where a user wants to investigate a wide range of temperature dependent measurements but the cryocooler needs to be protected thermally since it has typically a maximum permissible temperature of 35°C). If the heater itself is mounted on-board the puck this becomes much easier to achieve.

A number of advantages follow from this:
1) The properties of the ceramic which provide the electrical isolation are chosen to have a higher thermal conductivity below 200K than at room temperature or elevated temperatures. Below 200K the thermal conductivity of the ceramic is typically more than one to two orders of magnitude higher compared with typical circuit board material. At low temperatures the thermal properties of the ceramic assist the cooling function provided by the cryocooler. At high temperatures, the thermal properties assist in protecting the cryocooler.
2) Users wish to have a convenient method of mounting samples (e.g. for material characterisation etc) for example a "plug-in" mounting, to provide efficient cooling, together with DC and RF connections to enable simultaneous optical and electrical sample characterisation.
3) The sample holder provides a robust technology compared with a normal circuit board.
4) The novel use of copper coated ceramic circuit board (using a very thick layer of oxygen free copper which is high conductivity copper), provides a high level of thermal conductivity and thermal mass offering improved temperature stability and uniformity.

The sample holder is therefore a more convenient sample holder in terms of use by an end user when compared with known sample holding techniques, and particular advantage is provided by sample holders having the ceramic-based printed circuit board.

The sample holder provides a convenient platform to provide a variety of sample interfaces, for example to customise the measurement area. The sample puck allows a more sophisticated interface with additional functionality on the sample puck in addition to the on-board heater and temperature sensor, as required.

The chip-on-board concept reduces the number of thermal interfaces. This is important as the cooling performance is lost at the interfaces. It also enables simple and reliable DC and RF connectivity by virtue of the inherent puck design. The example designs described in more detail below provide a reliable DC / RF connection close to the sample area, in a plug-in configuration. Thermal properties are greatly enhanced due to the quality and thickness of the copper layer compared with classic epoxy based circuit boards and the thermal conductivity of the ceramic dielectric vs. conventional epoxy based circuit board materials add additional benefits.

A normal circuit board has relatively poor thermal conductivity. The use of copper clad ceramic (such as AIN or Alumina) provides much higher thermal conductivity in comparison with a normal circuit board.

In this application it is advantageous for such a circuit board to be double sided because it creates a thermal mass which provides a (thermally) stabilising effect and balances the stress of the copper and ceramic materials due to their different expansion coefficients as the puck is cycled through a wide temperature range from ≤4K to ≥450K. It provides a quick and convenient sample changer, a reproducible thermal environment, and a more systemised approach to connections with high reliability including high frequency measurements in excess of 10 GHz.

The double sided circuitry on the first and second opposing faces of the sample holder is designed to provide efficient cooling to the sample region and electrically isolated and electrically connected areas through 'via' holes between the two sides of the sample holder. These electrical connections may be designed to provide DC- as well as RF-measurement capability up to at least 12GHz.

Whilst a double sided circuit board is not essential, it provides an additional benefit. When using a single sided circuit board it may be necessary for the circuit side to be facing away from an 'access side' of the use, that is, the side the user sees when s/he screws the sample holder (circuit board) onto the sample support. Having a double sided circuit board opens up the opportunity for two parallel experiments or the opportunity to use one side repeatedly and, after such a side becomes worn or damaged, the user can use the second side.

### Brief Description of the Drawings

Some examples of sample holding systems according to the invention are now described with reference to the accompanying drawings, in which:
Figure 1 is a schematic illustration of a sample support of a first example sample holding system;
Figure 2 is a schematic illustration of a sample holder of the first example sample holding system;
Figure 3 is a schematic illustration of a sample support of a second example sample holding system;
Figure 4 illustrates a reverse side of the sample holder of the second example;
Figure 5 is a perspective view of a third example sample holding system, including radio frequency connectors;
Figure 6 illustrates a fourth example sample holder formed using a copper-ceramic laminate substrate;
Figure 7 illustrates a fifth example sample holder having dimpled regions.

### Detailed Description

We now describe a number of examples of a sample holder system for attachment to cryogenic apparatus in accordance with the invention. Each of these examples can be thought of as a two-part system, the first part being a support member which is mounted to the cooled stage of a cryocooler (mechanical refrigerator). The second part is a sample holder in the form of a "puck" which is attachable to and detachable from the support member. The use of a two-part system with a separable sample holder provides numerous practical and technical advantages over known sample holders. In particular, the sample holder may be removed and positioned at a location where a sample may be conveniently mounted to the sample holder, together with electrical connections between the sample and the contact pads of the sample holder using soldering or wire bonding techniques.

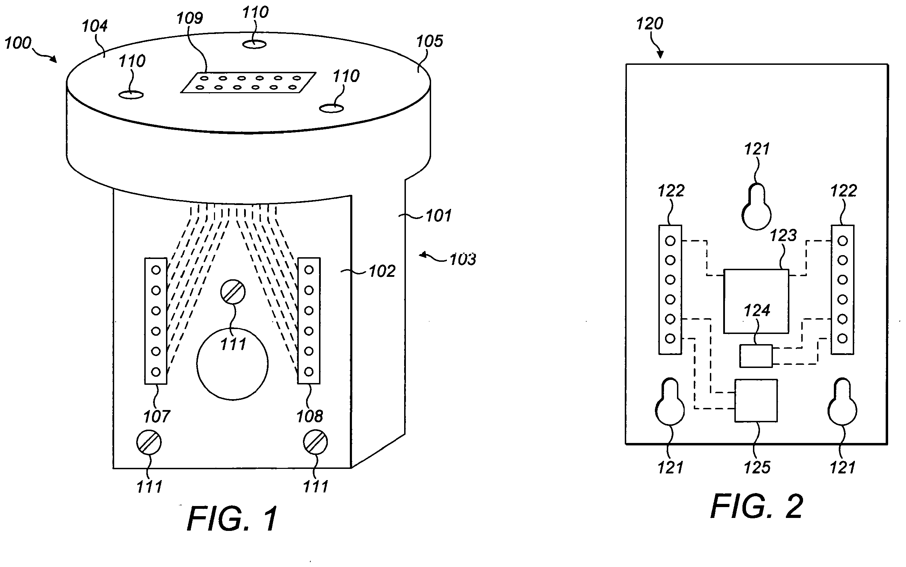

Figure 1 schematically illustrates a first example system 100 in which a support member 101 is illustrated. The support member 101 generally takes the form of a right rectangular prism having two major (largest) faces on opposing sides. These are illustrated at 102 and 103 in the illustration of Figure 1. The primary faces serve as locations for mounting one or two sample holders (one for each face as desired) as will be explained. At one end of the rectangular prism is situated an end part in the form of a circular plate 104. The circular plate 104 is mounted orthogonally to the end of the right rectangular prism so that it presents a thermal contact surface 105 having a plane normal which is parallel with the prism axis. The diameter of the circular plate 104 is, in this example, the same as the width dimension of the primary faces, 102, 103 in a direction which is normal to each of the plane normal of the thermal contact surface 105 and primary faces 102, 103. In practice, the support member 101 is formed from a monolithic piece of high conductivity copper material.

Each primary face 102, 103 is rectangular in geometry, with the dimension which extends away from the circular plate 104 (along the prism axis) being larger than the width of the primary faces. This therefore defines a "length" dimension. At a position approximately 60 to 70 percent along the length dimension away from the circular plate 104, a circular aperture 106 is provided which passes as a through bore between the primary faces on opposing sides of the support member. The circular aperture 106 provides for the passage of electromagnetic radiation when the sample holder is used for optical measurements for example. On either side of the circular aperture on the primary face 102 is positioned a linear array of six contact pins, each array being parallel and extending in the length dimension. These arrays are illustrated at 107, 108. Each contact pin in each array is deflectable in a direction normal to the primary face and is biased so as to project away from the face for engagement with a corresponding portion on the sample holder to be described. Wiring from each of the pins (shown schematically in Figure 1) is provided between each pin and an electrical connector 109 which is positioned centrally in the thermal contact surface 105 of the circular plate 104. These components provide electrical connection between each of the pins in the arrays 107, 108 of the primary face 102, and the electrical connector 109. This arrangement enables electrical power and signals to be communicated to and from the support member 101 via the connector 109.

When the sample holder system 100 is in use, the support member is mounted to a cooled stage of a cryocooler by bolts illustrated at 110 which project from the thermal contact surface 105, this projection being upwards in Figure 1. The surface 105 makes a strong thermal contact with the cooled stage of a cryocooler against which it abuts when in use and, at the same time, electrical connections are made with the electrical connector 109, for example these leading away to power, monitoring and control systems of the apparatus as a whole. Typically such systems will include a computer such as a PC running appropriate software to control an experiment being performed in relation to a sample held on the sample holder to be described.

Returning to the primary face 102 of the sample holder 101, three screws 111 are positioned in corresponding threaded bores in the surface of the primary face 102. These serve as the attachment mechanism for a sample holder which is now described in association with Figure 2.

Referring to Figure 2, a sample holder 120 is illustrated. This takes the general form of a piece of rectangular printed circuit board (PCB) the dimensions of which are arranged to be generally similar to that of the primary faces 102, 103 although slightly shorter in length dimension. In practice the length and width dimensions of the PCB 120 may be a few centimetres in each case, with a thickness of around 1 millimetre (typically 0.5 to 1.8mm). The sample holder is provided with three through thickness apertures 121 having a mutual positioning which corresponds to that of the screws 111. Each aperture is of a shape which is generally circular with a narrow extension projecting for a short distance (upwardly in Figure 2) along the length of the PCB 120. The purpose of this geometry is to allow the screws 111 of the support member 101 to be unscrewed a few turns to allow the screw heads to project away from the primary face 102. The circular parts of the apertures 121 are of sufficient dimensions such that the screw heads may pass through them. However, the projections are dimensioned such that the shaft of each screw may pass through the projection but the head of each screw may not. Thus, the sample holder 120 may be attached to the support member 101 by unscrewing the screws 111 a few turns, passing each of the screws through their corresponding apertures in the sample holder 120 and then moving the sample holder 120 slightly in the length dimension (downwards in this case) such that the shaft of the screws move into the projections of the apertures 121. Thereafter the screws 111 may be tightened and the sample holder is then securely mounted to the support member. The reverse process is used to remove the sample holder 120 and it will be understood that this process may be repeated effectively indefinitely.

It will be recalled that two linear arrays 107, 108 of biased contact pins are provided on the support member 101. Two arrays of corresponding contact locations are provided at corresponding positions on the sample holder 120 so as to provide electrical contact when the pins are in contact with the contact locations. These are illustrated at 122. A sample region 123 is positioned between the arrays 122 and approximately centrally between the three apertures 121. The sample region 123 may take a number of specific forms depending upon the type of sample which is desired to be analysed. In this case it takes the form of an integrated circuit chip carrier which may be used to investigate devices such as gallium arsenide devices, MEMS and other semiconductor components. The dashed lines 124 in Figure 2 illustrate electrical connections within the PCB between a number of the connection locations of the arrays 122 and the support region 123. It will be understood here that certain devices may be actually operational during the experiments to be performed and therefore power and electrical signals may be supplied via the arrays 122. Furthermore, it will also be noted that the position of the sample region 123 corresponds with that of the aperture 106 in the sample support and therefore, if the sample region 123 is provided with an aperture, then electromagnetic radiation may be impinged upon or received from the sample region via the appropriate aperture, including aperture 106 if desired. Adjacent the sample region 123 is located a small temperature sensor 124. As illustrated, this is also connected to the array of connectors 122. Such a temperature sensor may be only a few millimetres in dimension and may be a four lead type sensor with two leads being provided for the supply current and two to provide for voltage monitoring.

A planar heater 125 is also provided in the sample holder of this example. This is located in the lower part of the sample holder as illustrated in Figure 2 and is therefore distal from the end of the sample holder which is closest to the cryocooler when in a mounted position. In the present case the heater is formed from a thin planar Nichrome film which is positioned on the top of a layer of aluminium nitride. As will be understood, the heater 125 and temperature sensor 124 can be used together, with appropriate control circuitry or software so as to provide a highly defined temperature environment for the sample region 123.

As is applicable to all examples described herein, the use of a two-part system having a support member and detachable sample holder is particularly beneficial from the perspective of users. For example, a user wishing to investigate the properties of a particular sample device may conveniently take the sample holder to an appropriate laboratory location and carefully attach the device to the sample region 123 under controlled conditions. In particular, there is no need for the user to work in a confined space or in an awkward orientation due to the symmetrical constraints provided by the cooling apparatus. Instead, the user may work conveniently and easily on the small sample holder which is a readily removable component. The generally planar and compact form of the sample holder allows the user to use wire bonding techniques to ensure each of the connections are made with the sample in the sample region. Conveniently, the temperature sensor 124 and/or heater 125 may be provided pre-mounted to the sample holder by a supplier. It is conceivable also of course that they may be mounted to the sample holder separately.

Having placed the sample in the sample region 123 and having made all the required electrical connections in the laboratory, the user may then conveniently transport the sample holder to the location of the experimental apparatus including the cryocooler and attached support member 101. It is a simple matter to pass the screws 111 through the apertures 121 and allow the sample holder 120 to move under gravity for example so as to engage the screw shafts within the projections of the apertures 121. In doing so, the arrays of locations 122 move easily over the corresponding array 107, 108 of the support member 101 such that, when in the final resting position, each pin in the array 107, 108 projects towards a corresponding contact location in the array 122. The sample support may then be safely released by the user and the screws 111 tightened. In tightening the screws the contact locations in the arrays 122 on the rear side of the sample holder are forced against the biased pins such that a strong physical and electrical contact is made. Furthermore, the general surrounding surface of the rear side of the sample holder (which is gold plated) is placed into strong thermal contact with the general surface of the primary face 102. In this way reliable electrical connections are made, together with a strong thermal connection between the sample holder and sample support member surfaces. Thus the screws 111 are tightened, the appropriate electrical connections are therefore made between the connector 109 in the thermal contact surface 105 and the respective components, including the sample, of the sample holder 120.

Once the sample holder is securely mounted and all electrical connections made, the support member and sample holder may be then placed in a stable environment such as inside a cryostat and appropriate experiments are formed as desired by the user.

In the examples described herein, a very substantial temperature range of operation is contemplated. For example, in the present example the lowest temperature obtained may be around 2.5 to 4 Kelvin, depending upon the performance of the cryocooler, whereas the highest temperature used may be around 380 to 400 Kelvin, above which the printed circuit board material of the sample holder will likely malfunction. The lowest temperature of around 2.5 to 4 Kelvin may be obtained by isolating the system in a cryostat and operating a sufficiently powerful cryocooler so as to reach an operational base temperature of 2.5 to 4 Kelvin. In addition to the thermal performance of the sample holder and sample support member, it is necessary to protect the cryocooler from high temperatures. In practice it should be ensured that the cooled stage of the cryocooler does not reach a temperature in excess of about 310 Kelvin. In the case of high temperatures, a greater challenge exists since it may be necessary to protect the cryocooler from exposure to high temperatures. This is achieved by placing the heater 125 away from the cryocooler cooled stage and also placing it very close to the sample region. Nevertheless, this does present some challenges particularly in terms of the thermal gradients which may be established during such an operation and the controllability of the temperature of the sample region for any particular duration at high temperature.

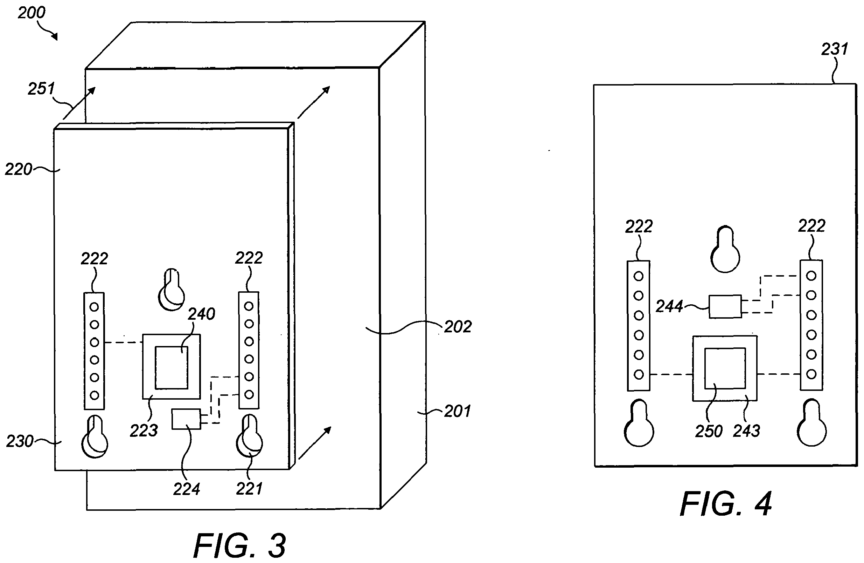

A second example is illustrated in association with Figures 3 and 4. In this example components having a similar functionality to those in the first example are denoted by reference numerals having similar second and third digits. The second example has a sample holder 220 which is a "two-sided" sample holder. In particular, a first side is used for the receipt of a sample and therefore forms an experimental side 230 of the sample holder 220. This is provided with a sample region 223 which, as is shown in Figure 3, retains a sample 240. Through-thickness apertures 221 provide a similar attachment mechanism as in the first example. In the present case the two-sided sample holder 220 is not provided with an on-board heater although such a heater could readily be supplied if the anticipated use of the sample holder required it. Figure 4 shows a schematic illustration with the arrangement of components on the other side of the sample holder 220, that is, the side opposite to the experimental side 230. The other side in this case is a reverse side 231, in this case for providing a control experiment on the same sample holder. A second temperature sensor 244 which is similar to the sensor 224, is provided, although in a more central location with respect to the edges of the reverse side 231. A control sample region 243 is located at a position which corresponds as a mirror image of the sample region 223. A control sample 250 is located in the control region 243 and it will be noted from Figure 4 that, for example, connections are provided via the arrays 222. As for the first example, each contact location in the array is provided as a via such that electrical contacts may be made on either side of the sample holder 220. Although the experimental and reverse sides 230, 231 are generally similar in arrangement, although have different components, in the case of the reverse side 231 of the present example, when in use this is urged against the primary face 202 of the support member 201 as is illustrated by the arrows 251 in Figure 3. It will be noted that the support member 201 of the system 200 is shown schematically in Figure 3. The large area contact between the reverse side 231 of the sample holder and the primary face 202 provides excellent thermal contact. However, in this case, any components such as the control sample 240 and the arrays 222 and the reverse side 231 should be provided with appropriate electrical insulation in the form of either an additional covering layer or by appropriate use of the design of the integral circuitry within the PCB. It is also contemplated that, in order to ensure a good thermal connection, the components may need to be recessed into the surface and/or one or more raised regions may need to be provided to effect the thermal contact so as to accommodate the physical thickness of the components on the reverse side 231. Likewise, alternatively or in addition, the surface of the support member could be configured with recesses or projections to achieve a similar thermal contact function.

Such a two-sided design provides the ability to perform simultaneous monitoring of two sample devices for example. Of course, it is not necessary that the reverse side used to provide a control experiment. It can instead, in some cases, be used simply to provide a second experiment for more efficient use of the apparatus. The other advantages provided by the first example are provided by the second example also, in particular regarding the ease of handling of the sample holder 220 and the attachment and detachment from its respective support member 201.

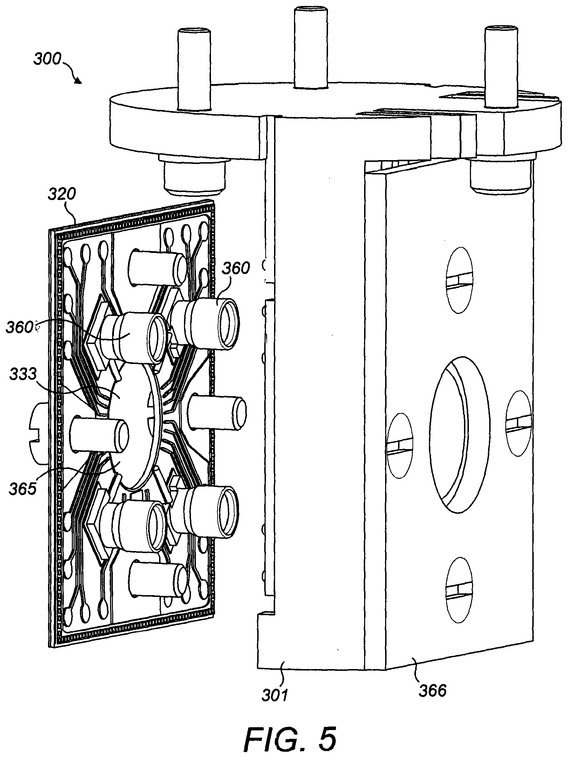

It will be understood that there exist numerous different possible arrangements of connections and components for implementing the invention. Likewise, there exist other alternative approaches to the method by which the mechanical attachment of the sample holder 120, 220 may be achieved to its respective support member 101, 201. An example of such an alternative arrangement is illustrated in Figure 5.

Figure 5 illustrates a third example system 300. In this case the support member 301 is used to support and provide connections with a sample holder 320 which provides 20 direct current (DC) connections and 4 radio frequency (RF) connections with a sample region 333. As is illustrated in Figure 5, the 4 RF connectors 360 project from the surface of the sample holder 320 and mate with corresponding connectors mounted to the support member 301. This particular sample holder 320 is equipped with a large central aperture 365 so as to provide for simultaneous optical experiments via an aperture in the support member 301 at a corresponding location. The plate on the rear side of the support member 301 is a cover plate 366 which allows assembly of the connectors which mate with the 4 RF connectors 360.

In this case, the attachment of the sample holder 320 to the support member 302 is provided by 4 screws which are arranged symmetrically about the aperture 365 and pass through threaded bores in the PCB material in regions which are formed from extensive areas of copper (optionally gold plated) so as to provide a strong thermal contact.

Each of the above examples utilises a PCB substrate for providing the sample holder. As has been mentioned, the upper operational temperature of the PCB material is around 380 Kelvin. In similar applications it is desirable to perform experiments upon a sample in an even greater operational temperature range and therefore at temperatures in excess of 380 Kelvin. For this reason, an alternative material may be used as a replacement for the PCB.

The applicant has realised that such an alternative material can be provided in the form of a laminate of a ceramic substrate with a relatively thick layer of oxygen free copper on one or preferably each of the two major surfaces of such a planar substrate. Circuit boards (designed for a different application), formed from such a material may be obtained from Rogers Corporation (www.curamik.com). It will be understood that such a material may be used in place of the PCB material for each of the first and third examples discussed herein. In comparison with the PCB material the ceramic substrate material has a similar appearance and thickness as a whole. Further, the relative thickness of the copper layers in comparison with the PCB material is significantly increased. For example in a PCB material the copper layer thickness may be around 35 micrometres whereas that in the ceramic laminate may be around 200 micrometres thick. Therefore the ceramic material may have a ceramic substrate of around 380 micrometres thick with a copper layer on each side of the substrate of around 200 micrometres thick. The copper material is oxygen free copper which is a particularly good thermal conductor.

An advantage of using a ceramic based substrate, particularly where a ceramic such as alumina (Al₂O₃) is used in polycrystalline form, is the thermal conductivity of ceramics such as alumina, together with silicon nitride and aluminium nitride is very high at low temperatures (below about 100 Kelvin for example), in comparison with a PCB substrate. This is particularly beneficial when using the material for low temperature experiments since the substrate assists in providing the cooling power of a cryocooler to the sample. However, at high temperatures, not only is the combination of a ceramic and copper able to physically withstand higher temperatures than a PCB material, a further advantage is provided by the use of a ceramic in that, compared with operation below 200K, ceramic materials have a lower thermal conductivity at temperatures above 200K and in particular above room temperatures and at elevated temperatures. This means that, with the use of localised heating of the sample, the conductivity of heat to the cryocooler is reduced by the thermal impedance of the ceramic material.

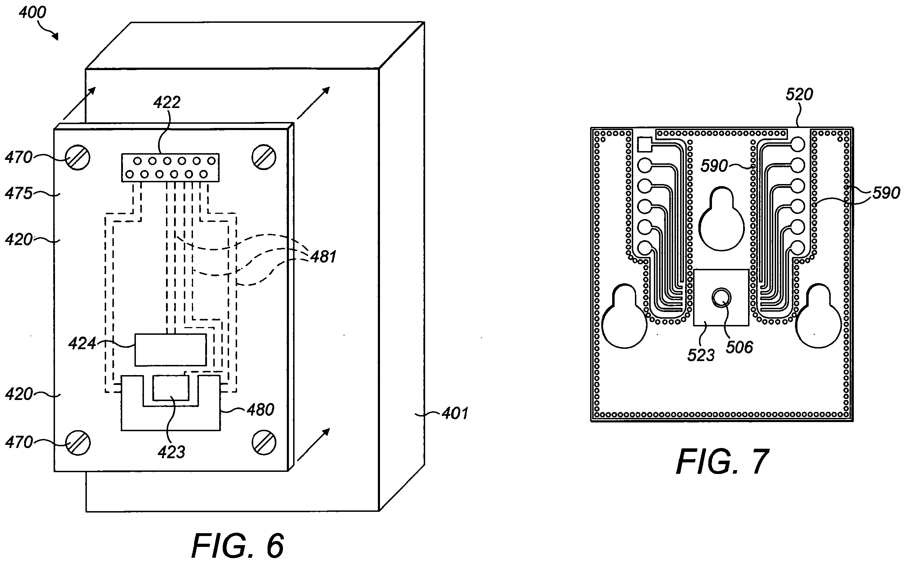

Referring now to Figure 6, a sample holder 420 is illustrated as part of a system 400. The sample holder 420 is attached to a support member 401 by screws 470 located in the corners of the copper-ceramic laminate substrate 475. A heater 480 in the form of a planar microfilm is arranged to partially surround a sample region 423. An adjacent temperature sensor 424 is provided so as to measure the temperature of the sample region 423 when in use. In this case a single connector array 422 is located along an upper edge of the sample holder 420. It will be noted that this is distal from the heater 480, sample region 423 and temperature sensor 424 which are each located in the vicinity of the opposite edge (lower in Figure 6). This arrangement is designed to maximise the thermal isolation of the heater 480 from the cryocooler and indeed the connector 422. As are schematically illustrated at 481, the copper surface of the laminate material is arranged to provide conductive circuitry tracks which are integral with the material.

Thus it will be understood, with the sample holder 420 and a corresponding support member 401, the system 400 may be used to conduct experiments in a range of temperatures between around 3 Kelvin and up to at least 410 Kelvin, more preferably 450 Kelvin. The higher temperature range in comparison with a PCB based sample holder represents a previously unobtainable operational temperature range for a sample holder capable of operating at cryogenic temperatures also. It will be understood therefore that the use of a ceramic-copper laminate enables scientific experiments and other component monitoring to be performed over a temperature range not previously possible with known sample holder systems.

Figure 7 shows a further sample holder 520. In this example the sample region 523 is a sample mounting area of approximate dimensions 10x10mm. A central hole (aperture 506) is located within region 523 to enable optical transmission. The sample holder 520 is provided with regions of dimples 590 in the form of a copper pattern containing small etched holes for stress relief. This pattern is located around the circumference of the copper areas. The dimples 590 are designed to reduce the stress at the edge of the copper layer, thereby substantially increasing the reliability and lifespan of the circuit. The stress which is relieved by the dimples is due to the thermal expansion mismatch between the dielectric, which can be either a hydrocarbon based PCB or ceramic material, and the copper. In experiments conducted by the applicant involving thermal cycling between about 3K and either ambient or elevated temperatures, the dimples were found to prevent damage or failure of the sample holders, and in particular to prevent delamination of the copper. The dimples therefore provide particular benefit in stress relief during thermal cycling involving cryogenic temperatures.

## Claims

1. A sample holding system (100) comprising a sample holder (120), the sample holder (120) comprising:
a substrate in the form of a circuit board;
one or more sample holder connectors (122) for providing electrical connection to the sample holder (120);
a sample region (123) for receiving a sample; and
circuitry (124) for providing electrical connection between the said sample holder electrical connectors (122) and a part of the sample holder, through the circuit board;
and **characterised in that** the circuit board comprises a high thermal conductivity ceramic substrate having a surface which is coated with a layer of copper having a thickness of at least 127 µm and being arranged to provide conductive circuitry tracks whereby the circuitry (124) is integral to the circuit board, and wherein the thermal conductivity of the ceramic is in excess of 20 W/m·K, preferably >100 W/m·K, at 20°C, such that the sample holder is adapted to operate over an operational temperature range of below 1K to at least 410K.

2. A sample holding system according to claim 1, wherein the circuitry (124) is arranged to provide electrical connection between the sample holder electrical connectors (122) and at least the sample region (123).

3. A sample holding system according to any of the preceding claims, wherein the sample holder (120) further comprises a heater (125) for heating the sample region (123), wherein the heater (125) is preferably arranged as a film heater mounted to a surface of the circuit board.

4. A sample holding system according to any of the preceding claims, wherein the sample holder (120) further comprises a temperature sensor (124) for monitoring the temperature of the sample when in the sample region (123).

5. A sample holding system according to any of the preceding claims, wherein the sample holder (120) is generally planar having first and second opposing faces and wherein the said sample region (123) is arranged on the first face thereof, wherein preferably the first face is an experimental side and wherein the second side is a reverse side of the sample holder, the reverse side further comprising one or more of, a further sample region, a further heater, or a further temperature sensor.

6. A sample holding system according to claim 5, when dependent upon claim 3, wherein the heater (125) is located on the first face.

7. A sample holding system according to claim 5, when dependent upon claim 4, wherein the temperature sensor (124) is located on the first face.

8. A sample holding system according to any of the preceding claims, wherein the sample region (123) is provided with a window for the provision of optical transmission measurements of or optical interaction with the sample region.

9. A sample holding system according to any of the preceding claims, wherein the sample holder connectors (122) comprise electrically conductive vias so as to conduct electricity through the circuit board across the thickness dimension.

10. A sample holding system according to any of the preceding claims, wherein the circuit board is provided with one or more dimpled regions (590) which border areas of laminated conductor material, so as to provide a stress relief function when thermal cycling at cryogenic temperatures.

11. A sample holding system according to any of the preceding claims, further comprising a support (101) to which the sample holder (120) is reversibly coupled, when in use, and wherein the sample holder (120) is preferably reversibly coupled to the support (101) using one or more physical connectors (111), the sample holding system being arranged to allow a user to couple the sample holder to the sample support from an access side.

12. A sample holding system according to claim 11, wherein the support (101) is formed from a high thermal conductivity material.

13. A sample holding system according to claim 11 or 12, further comprising support connectors (107, 108) arranged to couple electrically with said sample holder connectors (122) when in use so as to provide said electrical connection from the sample support (101) to the sample holder (120), wherein preferably one or each of the sample holder connectors (122) and sample support connectors (107, 108) are spring loaded probe-pins or push-fit connectors.

14. A sample holding system according to any of the preceding claims, wherein the circuit board comprises a further layer of copper arranged such that each of two opposed planar surfaces of the high thermal conductivity ceramic substrate is coated with a layer of copper.

## Patentansprüche

1. Probenhaltesystem (100), umfassend einen Probenhalter (120), wobei der Probenhalter (120) umfasst:
ein Substrat in Form einer Leiterplatte;
ein oder mehrere Probenhalter-Verbindungsstücke (122) zum Bereitstellen elektrischer Verbindung mit dem Probenhalter (120);
eine Probenregion (123) zum Aufnehmen einer Probe; und
Schaltung (124) zum Bereitstellen elektrischer Verbindung zwischen den elektrischen Probenhalter-Verbindungsstücken (122) und einem Teil des Probenhalters durch die Leiterplatte hindurch;
und **dadurch gekennzeichnet, dass** die Leiterplatte ein keramisches Substrat mit hoher thermischer Leitfähigkeit mit einer Oberfläche umfasst, die mit einer Schicht Kupfer mit einer Dicke von mindestens 127 pm beschichtet ist und angeordnet ist, um leitfähige Schaltungsspuren bereitzustellen, wobei die Schaltung (124) mit der Leiterplatte einstückig ist und wobei die thermische Leitfähigkeit der Keramik 20 W/mK überschreitet, vorzugsweise > 100 W/mK bei 20 °C, sodass der Probenhalter angepasst ist, über einen Betriebstemperaturbereich von unter 1 K bis mindestens 410 K zu arbeiten.

2. Probenhaltesystem nach Anspruch 1, wobei die Schaltung (124) angeordnet ist, um elektrische Verbindung zwischen den elektrischen Probenhalter-Verbindungsstücken (122) und mindestens der Probenregion (123) bereitzustellen.

3. Probenhaltesystem nach einem der vorstehenden Ansprüche, wobei der Probenhalter (120) weiter ein Heizgerät (125) zum Erwärmen der Probenregion (123) umfasst, wobei das Heizgerät (125) vorzugsweise als ein an einer Oberfläche der Leiterplatte montiertes Filmheizgerät angeordnet ist.

4. Probenhaltesystem nach einem der vorstehenden Ansprüche, wobei der Probenhalter (120) weiter einen Temperatursensor (124) zum Überwachen der Temperatur der Probe, wenn in der Probenregion (123), umfasst.

5. Probenhaltesystem nach einem der vorstehenden Ansprüche, wobei der Probenhalter (120) im Allgemeinen planar ist, mit einer ersten und zweiten gegenüberliegenden Fläche, und wobei die Probenregion (123) auf der ersten Fläche davon angeordnet ist, wobei die erste Fläche vorzugsweise eine experimentelle Seite ist und wobei die zweite Seite eine Rückseite des Probenhalters ist, wobei die Rückseite weiter eins oder mehrere von einer weiteren Probenregion, einem weiteren Heizgerät oder einem weiteren Temperatursensor umfasst.

6. Probenhaltesystem nach Anspruch 5, wenn abhängig von Anspruch 3, wobei sich das Heizgerät (125) auf der ersten Fläche befindet.

7. Probenhaltesystem nach Anspruch 5, wenn abhängig von Anspruch 4, wobei sich der Temperatursensor (124) auf der ersten Fläche befindet.

8. Probenhaltesystem nach einem der vorstehenden Ansprüche, wobei die Probenregion (123) mit einem Fenster für die Bereitstellung optischer Transmissionsmessungen von oder optischer Wechselwirkung mit der Probenregion bereitgestellt ist.

9. Probenhaltesystem nach einem der vorstehenden Ansprüche, wobei die Probenhalter-Verbindungsstücke (122) elektrisch leitfähige Durchkontaktierungen umfassen, um Elektrizität durch die Leiterplatte hindurch quer durch die Dickenabmessung zu leiten.

10. Probenhaltesystem nach einem der vorstehenden Ansprüche, wobei die Leiterplatte mit einer oder mehreren mit Vertiefungen versehenen Regionen (590) bereitgestellt ist, die an Zonen von laminiertem Verbindungsstückmaterial angrenzen, um eine Spannungsabbaufunktion bereitzustellen, wenn bei kryogenen Temperaturen thermische Wechselbeanspruchung erfolgt.

11. Probenhaltesystem nach einem der vorstehenden Ansprüche, weiter umfassend einen Träger (101), an den der Probenhalter (120), wenn in Gebrauch, reversibel gekoppelt ist, und wobei der Probenhalter (120) vorzugsweise unter Verwendung eines oder mehrerer physikalischer Verbindungsstücke (111) reversibel mit dem Träger (101) gekoppelt ist, wobei das Probenhaltesystem angeordnet ist, um einem Anwender zu erlauben, den Probenhalter mit dem Probenträger von einer Zugangsseite zu koppeln.

12. Probenhaltesystem nach Anspruch 11, wobei der Träger (101) aus einem Material mit hoher thermischer Leitfähigkeit gebildet ist.

13. Probenhaltesystem nach Anspruch 11 oder 12, weiter umfassend Trägerverbindungsstücke (107, 108), angeordnet, um mit den Probenhalter-Verbindungsstücken (122) elektrisch zu koppeln, wenn in Gebrauch, um die elektrische Verbindung von dem Probenträger (101) mit dem Probenhalter (120) bereitzustellen, wobei vorzugsweise eins oder jedes der Probenhalter-Verbindungsstücke (122) und Probenträger-Verbindungsstücke (107, 108) federbelastete Sondenstifte oder Steckverbindungsstücke sind.

14. Probenhaltesystem nach einem der vorstehenden Ansprüche, wobei die Leiterplatte eine weitere Kupferschicht derart angeordnet umfasst, dass jede der zwei gegenüberliegenden planaren Oberflächen des Keramiksubstrats mit hoher thermischer Leitfähigkeit mit einer Kupferschicht beschichtet ist.

## Revendications

1. Système de support d'échantillon (100) comprenant un porte-échantillon (120), le porte-échantillon (120) comprenant :
un substrat sous la forme d'une carte de circuit ;
un ou plusieurs connecteurs de porte-échantillon (122) pour fournir une connexion électrique au porte-échantillon (120) ;
une région d'échantillon (123) pour recevoir un échantillon ; et
des circuits (124) pour fournir une connexion électrique entre lesdits connecteurs électriques de porte-échantillon (122) et une partie du porte-échantillon, par l'intermédiaire de la carte de circuit ;
et **caractérisé en ce que** la carte de circuit comprend un substrat en céramique à haute conductivité thermique présentant une surface qui est revêtue avec une couche de cuivre présentant une épaisseur d'au moins 127 µm et agencé pour fournir des pistes conductrices de circuit, selon lequel le circuit (124) fait partie intégrante de la carte de circuit, et dans lequel la conductivité thermique de la céramique est supérieure à 20 W/mK, de préférence > 100 W/mK, à 20 °C, de sorte que le porte-échantillon est adapté pour fonctionner sur une plage de températures de fonctionnement allant de moins de 1 K à au moins 410 K.

2. Système de support d'échantillon selon la revendication 1, dans lequel le circuit (124) est agencé pour fournir une connexion électrique entre les connecteurs électriques de porte-échantillon (122) et au moins la région d'échantillon (123).

3. Système de support d'échantillon selon l'une quelconque des revendications précédentes, dans lequel le porte-échantillon (120) comprend en outre un dispositif de chauffage (125) pour chauffer la région d'échantillon (123), dans lequel le dispositif de chauffage (125) est agencé de préférence sous la forme d'un dispositif de chauffage en film monté sur une surface de la carte de circuit.

4. Système de support d'échantillon selon l'une quelconque des revendications précédentes, dans lequel le porte-échantillon (120) comprend en outre un capteur de température (124) pour surveiller la température de l'échantillon quand il se trouve dans la région d'échantillon (123).

5. Système de support d'échantillon selon l'une quelconque des revendications précédentes, dans lequel le porte-échantillon (120) est généralement plan en présentant des première et seconde faces opposées et dans lequel ladite région d'échantillon (123) est agencée sur la première face de celui-ci, dans lequel de préférence la première face est un côté expérimental et dans lequel le second côté est un côté arrière du porte-échantillon, le côté arrière comprenant en outre un ou plusieurs parmi une région d'échantillon supplémentaire, un dispositif de chauffage supplémentaire, ou un capteur de température supplémentaire.

6. Système de support d'échantillon selon la revendication 5, quand elle dépend de la revendication 3, dans lequel le dispositif de chauffage (125) est situé sur la première face.

7. Système de support d'échantillon selon la revendication 5, quand elle dépend de la revendication 4, dans lequel le capteur de température (124) est situé sur la première face.

8. Système de support d'échantillon selon l'une quelconque des revendications précédentes, dans lequel la région d'échantillon (123) est pourvue d'une fenêtre pour la fourniture de mesures de transmission optique ou d'interaction optique avec la région d'échantillon.

9. Système de support d'échantillon selon l'une quelconque des revendications précédentes, dans lequel les connecteurs de porte-échantillon (122) comprennent des trous d'interconnexion électriquement conducteurs de manière à conduire l'électricité à travers la carte de circuit à travers la dimension d'épaisseur.

10. Système de support d'échantillon selon l'une quelconque des revendications précédentes, dans lequel la carte de circuit est pourvue d'une ou de plusieurs régions alvéolées (590) qui bordent des zones de matériau conducteur stratifié, de manière à fournir une fonction de relâchement des contraintes lors d'un cyclage thermique à des températures cryogéniques.

11. Système de support d'échantillon selon l'une quelconque des revendications précédentes, comprenant en outre un support (101) auquel le porte-échantillon (120) est couplé de manière réversible, lors de l'utilisation, et dans lequel le porte-échantillon (120) est de préférence couplé de manière réversible au support (101) en utilisant un ou plusieurs connecteurs physiques (111), le système de support d'échantillon étant agencé pour permettre à un utilisateur de coupler le porte-échantillon au support d'échantillon à partir d'un côté d'accès.

12. Système de support d'échantillon selon la revendication 11, dans lequel le support (101) est formé à partir d'un matériau à haute conductivité thermique.

13. Système de support d'échantillon selon la revendication 11 ou 12, comprenant en outre des connecteurs de support (107, 108) agencés pour se coupler électriquement auxdits connecteurs de porte-échantillon (122) lors de l'utilisation afin de fournir ladite connexion électrique depuis le support d'échantillon (101) au porte-échantillon (120), dans lequel de préférence un ou chacun des connecteurs de porte-échantillon (122) et des connecteurs de support d'échantillon (107, 108) sont des tiges de sonde à ressort ou des connecteurs à emboîtement.

14. Système de support d'échantillon selon l'une quelconque des revendications précédentes, dans lequel la carte de circuit comprend une couche supplémentaire de cuivre agencée de telle sorte que chacune des deux surfaces planes opposées du substrat en céramique à haute conductivité thermique est revêtue avec une couche de cuivre.
